# DEMANDE DE BREVET EUROPEEN

(11) **EP 1 411 544 A1**
(43) Date de publication de la demande: **21.04.2004**
(21) Numéro de dépôt: 03292344.3
(22) Date de dépôt: 24.09.2003
(51) Int. Cl.: H01L 21/02, H01L 27/08

(54) **Procédé et installation de dopage d'un motif d'éléments résistifs gravé**

(30) Priorité: 18.10.2002 FR 0213011
(71) Demandeur: STMicroelectronics S.A., 92120 Montrouge (FR)
(72) Inventeur: Gris, Yvon, 38210 Tullins (FR)
(74) Mandataire: Casalonga, Axel

(57) **Abrégé**

L'invention concerne un procédé de dopage sélectif d'éléments résistifs prédéterminés d'une puce électronique utilisable puce à puce.

Ce procédé comporte trois phases. La première phase consiste à charger électriquement et sélectivement certains éléments (3) du motif. La seconde phase consiste à apporter des dopants sur les éléments (3) chargés en fonction de leur état de charge. La troisième phase consiste en un recuit afin de faire pénétrer et d'activer les dopants.

## Description

L'invention concerne le domaine de la microélectronique. L'invention concerne en particulier un procédé et une installation de dopage sélectif d'un circuit intégré comportant un motif ou réseau d'éléments en silicium polycristallin déposé sur de l'oxyde.

Dans le cadre de la présente description, par motif, on entend un réseau d'éléments résistifs de type plots, pastilles, barreaux, ou autres, isolés les uns des autres et placés sur un substrat, avec interposition d'un oxyde.

Il est courant _dans les circuits intégrés de réaliser des résistances en silicium polycristallin. La valeur de cette résistance dépend du nombre d'atomes dopants introduits dans ladite résistance au cours du procédé de fabrication du circuit intégré.

Une méthode connue pour introduire localement des atomes dopants est de réaliser une opération de masquage avec de la résine photosensible et d'introduire, à travers les ouvertures de la résine, les atomes dopants par implantation ionique. Cependant cette opération est collective en ce sens que toutes les puces d'une même tranche et toutes les tranches d'un même lot sont réalisées à l'identique.

Pour certaines applications il est utile de différencier les tranches les unes des autres ou même les puces les unes des autres. C'est le cas par exemple si on veut inscrire une référence spécifique ou plus généralement si on veut écrire un programme spécifique dans une mémoire ROM (Read Only Memory) d'une unique puce. On peut réaliser un masque de photolithographie différent pour chaque inscription différente. La limite de cette méthode est vite atteinte à cause du coût prohibitif des masques utilisés en microélectronique.

La méthode communément utilisée pour réaliser ces opérations spécifiques est l'écriture directe sur tranche par un faisceau d'électrons, c'est-à-dire l'insolation par un faisceau d'électrons d'une résine sensible aux électrons. Le masque utilisé devient virtuel car il est inscrit sous forme d'un programme dans la machine d'insolation. Il est connu que la vitesse de traitement des tranches de ces équipements d'insolationi par faisceaux d'électrons est faible. Il faut non seulement décrire avec précision la frontière d'un élément du motif à réaliser, ce qui nécessite un faisceau très étroit, mais il faut également balayer la surface de tout l'élément de motif à insoler, ce qui impliquerait, a contrario, un faisceau de plus grande surface pour aller vite.

Les machines d'insolation par électrons sont également très complexes car il faut pouvoir positionner le faisceau d'électrons avec une grande précision afin de décrire des éléments de motif petits, de dimension inférieure à 0.1 µm.

Les machines d'insolation par électrons nécessitent des ressources importantes en informatique. Tout le masque à dessiner doit en effet être décrit sous forme de programme informatique. De plus la méthode d'insolation par un faisceau d'électrons apporte à la surface de la résine des charges électrostatiques susceptibles de dévier le faisceau d'électrons. Ainsi la forme d'un élément de motif décrit crée des effets électrostatiques influant sur la forme des éléments de motif adjacents. Ces effets de proximité compliquent singulièrement le programme d'écriture utilisé par la machine d'insolation par électrons qui doit les corriger. De plus ces effets de proximité limitent les dimensions minimales utilisables pour les motifs décrits par le faisceau d'électrons.

Un but de l'invention est donc de proposer un procédé et une installation de dopage permettant la programmation sélective et rapide de certains éléments d'un motif de certaines puces sur une même tranche, sans utiliser de masque spécifique et sans devoir utiliser une machine d'insolation par faisceau d'électrons.

Un autre but de l'invention est de proposer un procédé et une installation de dopage nécessitant un équipement plus simple que ceux utilisés pour l'écriture directe sur tranche par un faisceau d'électrons au niveau de des caractéristiques mécaniques, électroniques et de programmation.

Un autre but de l'invention est de proposer une méthode et une installation de dopage n'influant pas sur les dimensions minimales d'un élément de motif devant être dopé.

Ainsi, selon un premier aspect, l'invention a pour objet un procédé de dopage d'un motif d'éléments résistifs isolés électriquement comprenant les étapes consistant à
- charger électriquement et sélectivement les éléments dudit motif ;
- apporter des atomes dopants auxdits éléments, en fonction de leur charge ; et
- recuire le motif.

Selon un mode de mise en oeuvre, la charge électrique est apportée par un faisceau d'électrons ou un faisceau d'ions.

Selon un mode de mise en oeuvre, l'étape de chargement électrique des éléments résistifs comprend le chargement de l'ensemble du motif et le déchargement sélectif des éléments par un faisceau laser.

Selon un mode de mise en oeuvre, l'étape consistant à apporter les atomes dopants consiste à adsorber des ions à la surface des éléments chargés.

Selon un mode de mise en oeuvre, les ions sont produits par un plasma et sont constitués par des ions issus d'atomes choisis parmi le bore, l'aluminium, l'indium, le phosphore, l'arsenic, et l'antimoine.

Selon un mode de mise en oeuvre, l'étape consistant à apporter les atomes dopants consiste à implanter des ions à la surface des éléments non chargés avec une énergie inférieure à 100 eV.

Par exemple, les ions implantés sont issus d'atomes choisis parmi le bore, l'aluminium, l'indium, le phosphore, l'arsenic, et l'antimoine.

Les éléments du motif à doper sont avantageusement en matériau semi-conducteur, par exemple en silicium, germanium ou arséniure de gallium.

Selon un autre aspect, l'invention a également pour objet un procédé de fabrication d'un circuit intégré dans un substrat en silicium comportant les étapes suivantes :
- dépôt sur le substrat d' une couche isolante ;
- dépôt d'une couche de silicium sur la couche isolante ;
- gravure d'un motif d'éléments résistifs dans ladite couche de silicium ;
- apport sélectif d'une charge électrique sur des éléments prédéterminés ; et
- dopage des éléments en fonction de leur charge. ;

Selon un mode de mise en oeuvre, les éléments du motif devant être dopés sélectivement sont séparés par des lignes conductrices reliées à un potentiel fixe pendant la phase d'apport sélectif de la charge électrique sur lesdits motifs du réseau.

Enfin, selon l'invention, il est proposé une installation de dopage sélectif d'un motif d'éléments résistifs isolés électriquement, comportant trois chambres accessibles par un sas unique, caractérisé en ce que la première chambre comporte des moyens pour charger sélectivement un ou des éléments sélectionnés du motif, la deuxième chambre comporte des moyens pour doper les éléments en fonction de leur charge et la troisième chambre comporte des moyens de recuit.

Selon un mode de réalisation, la première chambre comporte des moyens pour générer un faisceau d'électrons et le focaliser à un endroit précis d'une tranche ; la deuxième chambre comporte des moyens pour générer un plasma d'ions dopants pouvant atteindre une tranche placée à proximité ; et la troisième chambre comporte des moyens pour effectuer un recuit rapide d'une tranche.

Selon un mode de réalisation, l'équipement comprend un SAS principal distribuant des tranches dans les trois chambres par l'entremise de sas secondaires.

Ces buts, caractéristiques et avantages de la présente invention, ainsi que d'autres, seront exposés en détail dans la description suivante de modes de réalisation particuliers, faite à titre non limitatif en relation avec les figures jointes parmi lesquelles :
La figure 1 est une vue en coupe d'un circuit intégré réalisé conformément à l'invention ;
La figure 2 est un schéma de principe d'une installation destinée à la programmation du circuit de la figure 1 ;
La figure 3 est une vue en coupe d'un circuit illustrant un autre mode de mise en oeuvre d'un procédé selon l'invention ;
La figure 4 illustre un troisième mode de mise en oeuvre d'un procédé selon l'invention.

Comme cela est usuel dans le domaine de représentation des composants semiconducteurs, les diverses vues en coupe ne sont pas tracées à l'échelle.

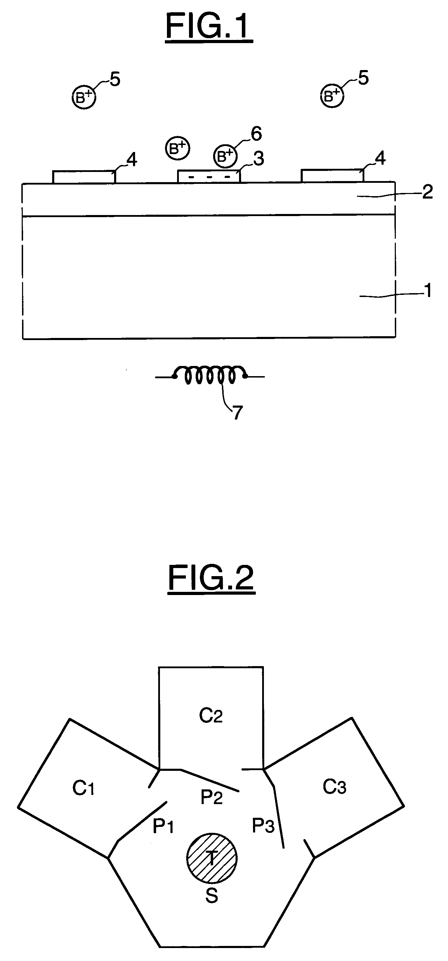

On décrit ci-après, en référence à la figure 1, un premier mode de mise en oeuvre d'un procédé de fabrication d'un circuit intégré conforme à l'invention.

Le substrat de départ pour la réalisation de l'invention est, par exemple, un substrat de silicium monocristallin 1 dans lequel on a, par les moyens usuels en technologie de microélectronique, réalisé des composants électroniques. Ces composants seront reliés électriquement, dans des étapes ultérieures du procédé de fabrication des circuits intégrés, par des niveaux d'interconnexions métalliques réalisés au sein d'un isolant électrique.

Avant ces étapes de réalisation des interconnexions métalliques on dépose sur toute la tranche un isolant diélectrique 2, par exemple 400 nm d'oxyde de silicium. Cette couche peut être beaucoup plus fine, par exemple 10 nm ou bien plus épaisse, par exemple 2 µm.

On dépose alors du silicium polycristallin. Il sera, de préférence très légèrement dopé de façon à présenter une résistance supérieure à 10 MΩ par carré. Cette résistance est ajustée par un moyen classique, par exemple une implantation ionique. L'épaisseur de la couche de silicium est de préférence comprise entre 20 et 600 nm, de préférence elle est de 200 nm.

On grave cette couche de silicium de manière à réaliser un motif d'éléments résistifs. Ce motif peut être formé de simples barreaux de silicium destinés à réaliser une fonction de résistance. Une coupe de la tranche obtenue est schématisée par la figure 1. On a représenté un élément résistif en silicium 3 flanqué de deux autres éléments résistifs 4 situés de chaque côté. Les dimensions minimales sont définies par les règles de dessin de la technologie utilisée pour réaliser le circuit intégré. On a alors, à cette étape du procédé, des éléments en silicium 3, 4 entièrement isolés électriquement les uns des autres et du substrat.

On apporte par un faisceau d'électrons une charge électrique négative sur certains éléments prédéterminés du motif, tel que l'élément désigné par la référence numérique 3 sur la figure 1.

Il existe des équipements d'observation par microscopie électronique à balayage des tranches de silicium pouvant être utilisés pour la mise en oeuvre de cette étape.

Ces équipements utilisent des faisceaux d'électrons de très faible intensité, inférieure à 10 pA, afin de ne pas charger électriquement les surfaces observées. Pour charger sélectivement un élément de motif 3, il suffit de programmer le faisceau d'électrons pour qu'il se positionne automatiquement au-dessus de l'élément.

On augmente alors l'intensité du courant du faisceau d'électrons afin de charger négativement l'élément. Par exemple un élément résistif de surface 0,2x2 µm, séparé d'un substrat conducteur par un oxyde d'épaisseur de 200 nm, présente une valeur capacitive par rapport au substrat de l'ordre de 0.7 10⁻¹⁶ F. Il suffit d'un courant d'électrons de 7 nA pendant 1 µs pour porter cet élément à un potentiel de -100V vis à vis du substrat. Cette valeur est déduite de l'équation de base : I=CV/t où I , C, V, t représentent respectivement le courant dans une capacité, la valeur de la capacité, la tension aux bornes de la capacité et le temps pendant lequel le courant circule.

Le potentiel est uniforme sur tout l'élément résistif 3 sélectionné car le silicium déposé a été rendu faiblement conducteur.

On place la tranche comportant les éléments 3 ainsi chargés négativement à proximité ou à l'intérieur d'un plasma d'atomes dé bore ionisés 5. Un tel plasma peut être obtenu en plaçant un gaz comme le B₂F₆ (fluoro di borane) dans un champ électrique de fréquence de plusieurs giga hertz. Par l'effet des forces électrostatiques des ions de bore (B+) chargés positivement, désignés par la référence 6, vont s'adsorber à la surface des éléments 3. Cette adsorption est uniforme puisque le silicium déposé est à un potentiel uniforme. A la place des ions de bore on peut utiliser des ions d'aluminium ou d'indium (A1+, In+).

On fait pénétrer les atomes de bore adsorbés à l'intérieur des éléments 3 en silicium en chauffant la tranche par exemple avec un système de recuit rapide.

A cet effet, des lampes halogènes 7 portent le substrat à environ 1000°C pendant 1s. Les éléments 3 ainsi dopés de type P deviennent fortement conducteurs. La résistance carrée de ces éléments 3 est de l'ordre de 100 Ω. Tout autre type de recuit, par exemple un recuit dans un four, est utilisable.

On notera que la sélection de certains éléments 3 de certaines puces de la tranche est faite pendant l'étape du chargement électrique du motif 3. L'équipement utilisé pour réaliser cette étape ne nécessite pas de disposer de performances très élevées car il suffit seulement que la position des éléments soit en mémoire (et non leur forme comme pour l'écriture par faisceau d'électrons précédemment décrite). Il suffit également que la précision des déplacements assure le positionnement du faisceau d'électrons au-dessus des éléments sélectionnés sans plus de précision. Enfin le temps d'écriture de chaque motif est particulièrement court car le courant du faisceau d'électrons peut être augmenté fortement.

Le potentiel de -100 V choisi dans l'exemple est élevé. Il résulte d'un compromis entre plusieurs paramètres :
- le temps de rétention voulu pour ce potentiel qui décroît au cours du temps à cause des fuites du courant inhérent à tout élément chargé posé sur une surface ;
- la tenue en tension de l'oxyde sous-jacent ;
- la proximité des autres éléments 4 qui ne doivent pas être perturbés par le champ électrique entourant l'élément 3 pendant l'étape d'adsorption ;
- la quantité de dopant à adsorber.

En pratique le potentiel d'un élément résistif 3 est supérieur à 5 volts et inférieur à 500 volts.

La fin de processus de fabrication de la tranche est classique : on dépose un isolant, par exemple de l'oxyde. Des opérations de photolithographie permettent de graver des trous de contact et de réaliser des niveaux d'interconnexions métalliques entre les différents composants électroniques du circuit intégré et les éléments 3 et 4.

Il existe de nombreuses variantes, ou modes de réalisation de cette invention. Ainsi qu'il a été décrit dans le premier mode de réalisation la méthode de dopage comporte trois phases distinctes :
- une première phase : charge d'un élément isolé électriquement ;
- une deuxième phase : apport d'une espèce dopante ; et
- une troisième phase : recuit.

Chacune de ces phases est sujette à divers modes de réalisation.

La conception d'un équipement de microélectronique dédié à la réalisation de l'invention améliore la qualité de réalisation de cette invention. En effet il faut que le temps s'écoulant entre la première et la troisième phase précédemment décrites soit le plus court possible afin d'assurer un potentiel constant des éléments 3 au début de la deuxième phase et une population d'ions adsorbés répétitive au début de la troisième phase.

On va maintenant décrire en relation avec la figure 2 la réalisation d'un équipement permettant de réaliser de manière optimale l'invention.

Cet équipement de salle blanche comporte trois chambres C1, C2, C3 reliées à un sas commun S par des sas secondaires P1, P2, P3.

La chambre C1 est dédiée à la première phase et comprend tous les moyens pour charger les éléments 3 avec un faisceau d'électrons. Le sas secondaire P1 permet de maintenir un vide optimum dans la chambre C1.

La chambre C2 est dédiée à la seconde phase et génère un plasma d'ions utilisable pour doper les éléments 3. Le sas secondaire P2 permet d'éviter une pollution du sas principal S par les espèces chimiques générées dans l'enceinte de C2.

La chambre C3 comprend les moyens pour effectuer un recuit rapide de type RTP (« rapid thermal processing », en anglais) de la tranche pour réaliser la troisième phase du procédé de dopage. Le sas secondaire P3 permet de maintenir l'environnement gazeux à la pression voulue, par exemple de l'argon, dans la chambre C3.

Le sas principal S comprend les moyens pour faire transiter rapidement une tranche T d'une chambre à l'autre. Le système de sas P1, P2, et P3 permet de minimiser les temps de transit entre le sas principal S et les diverses chambres C1, C2, C3.. S comprend en outre les moyens pour gérer un lot entier de 25 tranches, si nécessaire.

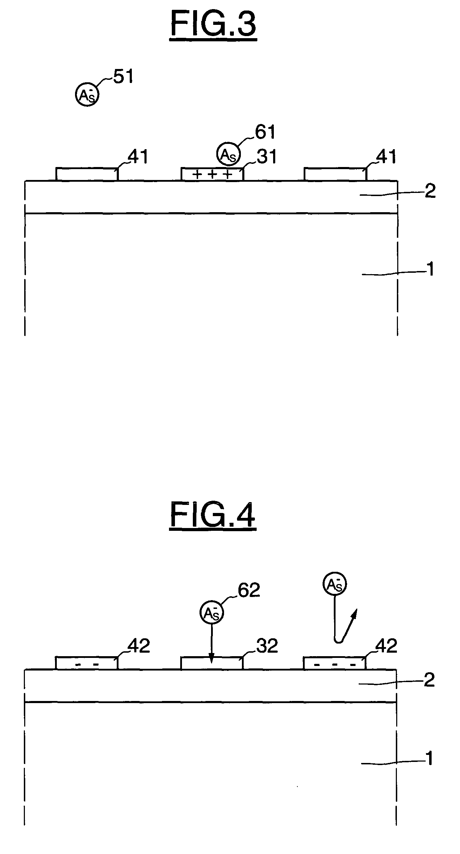

La figure 3 illustre un deuxième mode mise en oeuvre de la présente invention.

Durant la première phase, on charge à un potentiel positif les éléments résistifs 31 sélectionnés, par exemple avec un faisceau d'ions chargé positivement.

Durant la deuxième phase, on place la tranche dans un plasma d'ions 51 chargés négativement. Ces ions peuvent être des ions de phosphore, d'arsenic ou d'antimoine (P-, As-, Sb-). Ces ions s'adsorbent à la surface des éléments chargés positivement.

Durant la troisième phase on recuit la tranche. La résistivité des éléments 31 programmés diminue fortement. Ces éléments 31 ont un dopage de type N.

La figure 4 illustre un troisième mode de mise en oeuvre de la présente invention. Durant la première phase, on charge négativement des éléments gravés en silicium polycristallin, tels que les éléments désignés par la référence numérique générale 42, au moyen du faisceau d'électrons décrit précédemment. Durant la seconde phase, on réalise une implantation ionique de la tranche avec un faisceau d'ions 62 d'arsenic chargés négativement accélérés avec une faible énergie inférieure à 100 eV, par exemple 50 eV.

L'énergie cinétique de ces atomes d'arsenic est suffisamment faible pour qu'ils soient repoussés par la force électrostatique due à la charge de même signe des éléments 42. Seul les éléments 32, non chargés, subissent une implantation.

Durant la troisième phase, on recuit la tranche afin d'obtenir une faible résistivité pour les éléments 32 implantés. Des variantes de ce troisième mode de réalisation de la présente invention sont possibles. Ainsi, si les éléments sont chargés négativement, tout ion négatif comme ceux obtenus à partir d' atomes d'arsenic, de phosphore ou d'antimoine (As-, P-, Sb-) de faible énergie implantera les éléments complémentaires. A contrario, si le motif est chargé positivement, il faudra utiliser une implantation d'ions dopant chargés positivement obtenus à partir d'atomes de bore, d'aluminium ou d'indium (B+,Al+, In+).

On décrit maintenant un quatrième mode de mise en oeuvre de la présente invention.

Durant la première phase, on charge négativement toute la surface de la tranche. Pour cela on balaye toute la surface avec un faisceau d'électrons ou, plus simplement, on charge ladite surface en utilisant un peigne électrostatique porté à un fort potentiel négatif. Il est également possible de placer la tranche dans un fort champ électrique.

Ainsi, à ce stade de la première phase, la surface de la tranche, ainsi que les éléments en silicium gravés, comportent de nombreuses charges négatives. Une forte illumination de la surface, comme par exemple celle provoquée par un faisceau de lumière cohérente de type laser focalisé sur cette surface est capable, localement, de rendre conductrice cette surface.

A l'aide d'un faisceau laser, on décharge sélectivement certains éléments sélectionnés, les autres éléments en silicium restant à un potentiel fortement négatif. On est alors ramené aux modes de réalisation précédents.

On peut également apporter une charge positive sur la surface et éliminer localement les charges positives par une illumination laser. Un tel équipement laser en technologie de microélectronique capable de dessiner un motif dans de la résine existe pour réaliser les masques utilisables en technologie de microélectronique. Mutatis mutandis les problèmes posés par l'équipement d'écriture par faisceau laser et la solution apportée par la présente invention sont les mêmes que dans le cas d'une écriture directe sur tranche par faisceau d'électrons et dans le cadre du premier mode de réalisation.

Bien entendu la présente invention est susceptible de nombreuses variantes et améliorations qui apparaîtront à l'homme du métier.

En particulier les éléments du motif peuvent être alignés en réseau afin de faciliter leur intégration dans un plan de mémoire ROM. Chaque information 0 ou 1 du plan mémoire est représenté par un élément de motif conducteur ou non. L'homme du métier connaît les architectures et les décodeurs à utiliser pour lire un tel plan mémoire.

Chacun des éléments 3 et 4 peut être entouré d'une piste conductrice à la masse afin, par exemple dans le mode de réalisation 1, d'augmenter la latitude de précision de positionnement du faisceau d'électrons pendant la première phase et d'éviter tout effet électrostatique mutuel entre les éléments 3 et 4 pendant la deuxième phase.

On peut utiliser pour les éléments devant être dopés tout type de matériaux semiconducteur et en particulier du silicium amorphe ou monocristallin, du germanium.

On peut également utiliser des composés semiconducteurs comme par exemple de l'arséniure de gallium (AsGa).

Les ions utilisés peuvent être des complexes ioniques comportant plusieurs atomes et/ou possédant plusieurs charges électriques.

La méthode est applicable à partir du moment ou la conductivité du matériau isolé déposé est modifiable par un atome électriquement chargé.

La méthode est particulièrement applicable aux dispositifs de type SOI (silicon on insulator). Ces composants électroniques sont par exemple des transistors MOS avec une grille en silicium polycristallin. Il est possible en utilisant l'enseignement de l'invention de doper sélectivement certains transistors avec un dopant de type N appliqué sur la source, le drain et la grille et de doper d'autres transistors avec un dopage de type P appliqué sur la source, le drain et la grille. On obtient alors sélectivement des transistors à canal N et des transistors à canal P sur un isolant.

Les première et seconde phases des divers modes de réalisation peuvent être combinées durant un même- procédé de réalisation technologique afin de réaliser des éléments aux dopages et propriétés variés.

En utilisant les techniques de fabrication de la microélectronique on peut utiliser pour les éléments 3,4 des matériaux dont les propriétés physiques, magnétiques, optiques changent suivant les ions apportés en surface desdits matériaux.

## Revendications

1. Procédé de dopage d'un motif (3) d'éléments résistifs isolés électriquement, **caractérisé en ce qu'**il comporte les étapes consistant à :
- charger électriquement et sélectivement les éléments (3 ;31 ;32) dudit motif ;
- apporter des atomes dopants auxdits éléments, en fonction de leur charge ; et
- recuire le motif.

2. Procédé de dopage selon la revendication 1, **caractérisé en ce que** la charge électrique est apportée par un faisceau d'électrons ou un faisceau d'ions.

3. Procédé de dopage selon la revendication 1, **caractérisé en ce que** l'étape de chargement électrique des éléments résistifs comprend le chargement de l'ensemble du motif et le déchargement sélectif des éléments par un faisceau laser.

4. Procédé de dopage selon l'une quelconque des revendications de 1 à 3, **caractérisé en ce que** l'étape consistant à apporter les atomes dopants consiste à adsorber des ions (6 ;61 ;62) à la surface des éléments (3 ;31 ;32) chargés.

5. Procédé de dopage selon revendication 4, **caractérisé en ce que** les ions sont produits par un plasma et sont constitués par des ions issus d'atomes choisis parmi le bore, l'aluminium, l'indium, le phosphore, l'arsenic, et l'antimoine.

6. Procédé de dopage selon l'une quelconque des revendications de 1 à 3, **caractérisé en ce que** l'étape consistant à apporter les atomes dopants consiste à implanter des ions à la surface des éléments non chargés avec une énergie inférieure à 100 eV.

7. Procédé de dopage selon la revendication 6, **caractérisé en ce que** les ions implantés sont issus d'atomes choisis parmi le bore, l'aluminium, l' indium, -le phosphore, l'arsenic, et l'antimoine.

8. Procédé de dopage selon l'une quelconque des revendications 1 à 7, **caractérisé en ce que** les éléments (3 ;31 ;32) à doper sont réalisés en matériau semiconducteur.

9. Procédé de dopage selon la revendication 8, **caractérisé en ce que** le matériau des éléments à doper est du silicium, du germanium ou de l'arséniure de gallium.

10. Procédé de fabrication d'un circuit intégré dans un substrat (1) en silicium, **caractérisé en ce qu'**il comporte les étapes suivantes :
- dépôt sur le substrat (1) d' une couche isolante (2) ;
- dépôt d' une couche de silicium sur la couche isolante ;
- gravure d'un motif d'éléments résistifs (3, 4 ; 31, 41 ; 32, 42) dans ladite couche de silicium ;
- apport sélectif d'une charge électrique sur des éléments prédéterminés (3, 31, 32) ; et
- dopage des éléments (3, 31, 32) en fonction de leur charge.

11. Procédé selon la revendication 10, **caractérisé en ce que** les éléments (3, 4 ; 31, 41 ; 32, 42) devant être dopés sélectivement sont séparés par des lignes conductrices reliées à un potentiel fixe pendant la phase d'apport sélectif de la charge électrique sur le motif.

12. Installation de dopage d'un motif (3) d'éléments résistifs isolés électriquement, comportant trois chambres (C1, C2, C3) de traitement accessibles par un sas unique (S), **caractérisé en ce que** la première chambre comporte des moyens pour charger sélectivement un ou des éléments sélectionnés du motif, la deuxième chambre comporte des moyens pour doper les éléments en fonction de leur charge et la troisième chambre comporte des moyens de recuit.

13. Installation selon la revendication 12, **caractérisé en ce que** :
- la première chambre comporte des moyens pour générer un faisceau d'électrons et le focaliser à un endroit précis d'une tranche ;
- la deuxième chambre comporte des moyens pour générer un plasma d'ions dopants pouvant atteindre une tranche placée à proximité ; et
- la troisième chambre comporte des moyens pour effectuer un recuit rapide d'une tranche.

14. Installation selon la revendication 13, **caractérisé en ce qu'**il comprend un sas (S) principal distribuant des tranches dans les trois chambres (C1, C2, C3) par l'entremise de sas secondaires (P1, P2, P3).
